# DEMANDE DE BREVET EUROPEEN

(11) **EP 4 807 376 A1**
(43) Date de publication de la demande: **16.09.2026**
(21) Numéro de dépôt: 26162498.5
(22) Date de dépôt: 05.03.2026
(51) Int. Cl.: G01R 31/26

(54) **PROCEDE DE CARACTERISATION D'UN TRANSISTOR MOSFET**

(30) Priorité: 11.03.2025 FR 2502418
(71) Demandeur: Commissariat à l'Energie Atomique et aux Energies Alternatives, 75015 Paris (FR)
(72) Inventeur: VIEY, Abygaël, 38054 GRENOBLE CEDEX 09 (FR); BASSET, Léo, 38054 GRENOBLE CEDEX 09 (FR); GARROS, Xavier, 38054 GRENOBLE CEDEX 09 (FR); LACORD, Joris, 38054 GRENOBLE CEDEX 09 (FR)
(74) Mandataire: Cabinet Beaumont

(57) **Abrégé**

Procédé de caractérisation d'un transistor de type MOSFET (100), comprenant:
a) plusieurs applications d'une tension de contrainte sur la grille (110) du transistor, déclenchant un piégeage de charges dans son diélectrique de grille (112), et plusieurs déterminations d'une première caractéristique électrique de conduction du transistor (100), puis
b) plusieurs applications d'une tension de récupération sur la grille (112), déclenchant une libération de charges électriques piégées, et plusieurs déterminations de la première caractéristique électrique de conduction, puis
c) calcul, à partir des valeurs précédemment déterminées en mettant en œuvre les étapes a) et b) avec au moins deux valeurs différentes de la tension de contrainte, d'une dérive d'une deuxième caractéristique électrique de conduction du transistor (100), puis
d) détermination que le diélectrique de grille a été soumis ou non à un recuit de nitruration selon que la valeur du facteur d'accélération en tension p vérifie ou non la relation p = a×T_{OX} + b.

## Description

### Domaine technique

La présente description concerne de façon générale le domaine de la caractérisation de transistors MOSFET (« Metal-Oxide-Semiconductor Field-Effect-Transistor » en anglais, ou transistor à effet de champ à structure métal oxyde semi-conducteur), utilisée notamment pour déterminer si le diélectrique de grille d'un tel transistor a été soumis, lors de sa fabrication, à un recuit de nitruration, ou recuit nitruré.

### Technique antérieure

Un transistor MOSFET comporte, pour l'essentiel, une zone active comprenant un canal disposé entre une région de source et une région de drain, ainsi qu'une grille électriquement conductrice et un diélectrique de grille interposé entre la grille et le canal. La grille permet de contrôler de manière électrostatique la conduction du canal et donc la circulation d'un courant entre les régions de source et de drain à travers le canal.

Lors de la fabrication d'un transistor MOSFET, il est connu de mettre en œuvre un recuit de nitruration, ou recuit nitruré, dans le but notamment d'augmenter la valeur de la permittivité diélectrique du diélectrique de grille de ce transistor. Un tel recuit de nitruration a pour effet d'enrichir en azote le diélectrique de grille du transistor, ce qui a pour effet d'augmenter la constante diélectrique du diélectrique de grille, et donc son épaisseur équivalente à capacité égale. Cela permet ainsi de réduire les courant de fuites de la grille du transistor. Un tel recuit de nitruration agit également comme une barrière permettant de préserver le canal du transistor vis-à-vis d'impuretés (comme le bore) qui diffuseraient depuis le polysilicium de la grille. Des détails de mise en œuvre d'un tel recuit de nitruration sont par exemple décrits dans les documents B. Tavel et al., « Thin oxynitride solution for digital and mixed-signal 65nm CMOS platform », IEEE International Electron Devices Meeting 2003, Dec. 2003, p. 27.6.1-27.6.4., et M. L. Green et al., « Rapid thermal oxidation of silicon in N2O between 800 and 1200 °C: Incorporated nitrogen and interfacial roughness », Applied Physics Letters, vol. 65, no. 7, pp. 848-850, Aug. 1994.

Il est toutefois très difficile de détecter et déterminer, une fois le transistor achevé, si celui-ci a été soumis, lors de sa fabrication, à un recuit de nitruration.

### Résumé de l'invention

Il existe un besoin de proposer un procédé de caractérisation permettant de déterminer si un transistor MOSFET a été soumis, lors de sa réalisation, à un recuit nitruré.

Pour cela, un mode de réalisation propose un procédé de caractérisation d'un transistor de type MOSFET, comprenant au moins :
a) plusieurs applications d'une tension de contrainte V_{GStress} non nulle sur une grille du transistor, déclenchant un piégeage de charges électriques issues d'un canal du transistor au moins dans un diélectrique de grille du transistor, et plusieurs déterminations d'une valeur d'une première caractéristique électrique de conduction du transistor chacune mise en œuvre entre deux applications successives de la tension de contrainte V_{GStress} sur la grille, puis
b) plusieurs applications d'une tension de récupération V_{GRecovery} sur la grille, déclenchant une libération de charges électriques piégées, et plusieurs déterminations d'une valeur de la première caractéristique électrique de conduction du transistor chacune mise en œuvre entre deux applications successives de la tension de récupération V_{GRecovery} sur la grille, puis
c) calcul, à partir des valeurs de la première caractéristique électrique de conduction précédemment déterminées en mettant en œuvre les étapes a) et b) avec au moins deux valeurs différentes de la tension de contrainte V_{GStress}, d'une dérive Δ d'une deuxième caractéristique électrique de conduction du transistor telle que : $Δ = {\left[{Δ}_{SAT}^{- 1}+{Δ}_{0}⋅{V}_{GStress}^{- p}⋅{t}_{Stress}^{- n}⋅exp\left(\frac{{E}_{a}}{{K}_{B} T}\right)\right]}^{- 1}$ avec Δ₀ une valeur constante, Δ_{SAT} une valeur vers laquelle sature la dérive Δ, p un facteur d'accélération en tension, t_{Stress} une durée totale des applications de la tension de contrainte V_{GStress}, n une accélération temporelle, Ea une énergie d'activation, K_{B} la constante de Boltzmann, puis
d) détermination que le diélectrique de grille a été soumis ou non à un recuit de nitruration selon que la valeur du facteur d'accélération en tension p vérifie ou non la relation p = a×T_{OX} + b, avec T_{OX} l'épaisseur du diélectrique de grille, a une constante comprise entre 2 et 7 et b une constante comprise entre -3 et 7.

Selon un mode de réalisation particulier, la constante a est égale à 4,71, et/ou la constante b est égale à -1,83.

Selon un mode de réalisation particulier, la première et/ou la deuxième caractéristique électrique de conduction du transistor correspond à la tension de seuil V_{TH} du transistor, ou au courant de drain I_{DSAT} du transistor lorsque le transistor est en régime saturé, ou au courant de drain I_{DLIN} du transistor lorsque le transistor est en régime linéaire.

Selon un mode de réalisation particulier, les valeurs de la première caractéristique électrique de conduction du transistor sont chacune déterminées, lors de la mise en œuvre d'au moins l'une des étapes a) et b), à partir de mesures du courant de drain I_{D} en fonction de la valeur de la tension de grille V_{G}.

Selon un mode de réalisation particulier, chaque mesure du courant de drain I_{D} en fonction de la valeur de la tension de grille V_{G}, entre deux applications de la tension de contrainte V_{GStress} ou de la tension de récupération V_{GRecovery} sur la grille du transistor, est mise en œuvre pendant une durée inférieure à 10 µs.

Selon un mode de réalisation particulier, la valeur de la tension de contrainte V_{GStress} est comprise entre deux et trois fois la valeur de la tension de grille V_{G} destinée à être appliquée lors d'un fonctionnement nominal du transistor, et/ou la valeur de la tension de contrainte V_{GStress} est telle qu'un champ électrique E appliqué sur le diélectrique de grille soit supérieur à 9 MV/cm, avec E = V_{GStress}/T_{OX}.

Selon un mode de réalisation particulier, la tension de contrainte V_{GStress} est une tension continue ou en créneaux.

Selon un mode de réalisation particulier, la valeur de la tension de récupération V_{GRecovery} est nulle.

Selon un mode de réalisation particulier, les étapes a) et b) sont mises en œuvre en soumettant le transistor à une température comprise entre 25°C et 200°C.

Selon un mode de réalisation particulier, la durée totale des applications de la tension de contrainte V_{GStress} sur la grille et/ou la durée totale des applications de la tension de récupération V_{GRecovery} sur la grille est supérieure à 1 seconde.

Selon un mode de réalisation particulier :
- lors de l'étape a), lorsque la tension de contrainte V_{GStress} est appliquée sur la grille, un potentiel électrique de référence est appliqué sur une région de source et une région de drain du transistor, et/ou
- lors de l'étape b), lorsque la tension de récupération V_{GRecovery} est appliquée sur la grille, un potentiel électrique de référence est appliqué sur la région de source et la région de drain.

Selon un mode de réalisation particulier, le transistor comporte un substrat de type bulk ou FD-SOI.

Selon un mode de réalisation particulier, le transistor est de type N.

Selon un mode de réalisation particulier, le diélectrique de grille comporte du SiO₂ et/ou la grille comporte du silicium polycristallin dopé.

Selon un mode de réalisation particulier, il est également proposé un dispositif de mise en œuvre d'un procédé de caractérisation d'un transistor de type MOSFET tel que décrit ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
- la figure 1 et la figure 2 représentent des exemples de transistors MOSFET caractérisés lors de la mise en œuvre d'un procédé de caractérisation selon un mode de réalisation particulier ;
- la figure 3 représente schématiquement des étapes d'un exemple de procédé de caractérisation de transistor MOSFET selon un mode de réalisation particulier ;
- la figure 4 représente des exemples de caractéristiques du courant de drain I_{D} en fonction d'une tension de grille V_{G} d'un transistor MOSFET obtenues avant et après l'application d'une tension de contrainte sur la grille du transistor ;
- la figure 5 représente une configuration d'un transistor MOSFET et une tension de grille de ce transistor lors d'une première étape d'un procédé de caractérisation de ce transistor selon un mode de réalisation particulier ;
- la figure 6 représente une configuration d'un transistor MOSFET et une tension de grille de ce transistor lors d'une deuxième étape d'un procédé de caractérisation de ce transistor selon un mode de réalisation particulier ;
- la figure 7 représente des exemples de dérives ΔV_{TH} d'une tension de seuil V_{TH} d'un transistor MOSFET calculées lors d'un procédé de caractérisation de ce transistor, selon un mode de réalisation particulier ;
- la figure 8 et la figure 9 représentent des exemples de dérives ΔI_{DSAT} d'un courant de drain d'un transistor MOSFET fonctionnant en régime de saturation calculées lors d'un procédé de caractérisation de ce transistor, selon un mode de réalisation particulier ;
- la figure 10, la figure 11 et la figure 12 représentent des exemples de dérives ΔV_{TH} d'une tension de seuil V_{TH} d'un transistor MOSFET calculées lors d'un procédé de caractérisation de ce transistor, selon un mode de réalisation particulier ;
- la figure 13 représente des exemples de dérives ΔI_{DLIN} d'un courant de drain d'un transistor MOSFET fonctionnant en régime linéaire calculées lors d'un procédé de caractérisation de ce transistor selon un mode de réalisation particulier ;
- la figure 14 représente un exemple de relation entre la valeur d'un facteur d'accélération p calculée lors d'un procédé de caractérisation d'un transistor MOSFET et la valeur de l'épaisseur du diélectrique de grille de ce transistor.
- la figure 15 représente schématiquement un dispositif de mise en œuvre d'un procédé de caractérisation d'un transistor MOSFET selon un mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Sur les figures, afin de faciliter leur lecture, les différents éléments et les différentes couches de matériaux ne sont pas représentés à la même échelle les uns par rapport aux autres.

Par souci de clarté, seuls les étapes et éléments utiles à la compréhension des modes de réalisation décrits ont été représentés et sont détaillés. En particulier, différents éléments (circuit(s) appliquant les potentiels électriques souhaités sur les différentes électrodes du transistor caractérisé, circuit de lecture du courant de drain du transistor caractérisé, etc.) et différentes étapes mises en œuvre (calcul du facteur d'accélération à partir de la dérive, calcul de chaque paramètre définissant la dérive, etc.) ne sont pas détaillés. L'homme du métier sera à même de réaliser de manière détaillée ces éléments à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais « coupled ») entre eux, cela signifie que ces deux éléments peuvent être connectés ou être reliés par l'intermédiaire d'un ou plusieurs autres éléments. En outre, les termes « couplé », « relié » et « connecté » sont utilisés ici pour désigner des couplages, ou des liaisons, ou des connexions, électriques.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », « latéral », etc., ou à des qualificatifs d'orientation, tels que les termes « horizontal », « vertical », etc., il est fait référence, sauf précision contraire, à l'orientation des figures. Toutefois, ces termes ne présument pas de la position et de l'orientation réelles des éléments lors de son utilisation.

Sauf précision contraire, les expressions « environ », « approximativement », « sensiblement », et « de l'ordre de » signifient à 10 % près, de préférence à 5 % près.

De même, sans indication contraire, les gammes de valeurs indiquées incluent les bornes de ces gammes.

En outre, les signaux des différentes figures sont représentés schématiquement et non nécessairement à l'échelle les uns par rapport aux autres, autant pour les amplitudes que pour les durées des différentes parties de ces signaux.

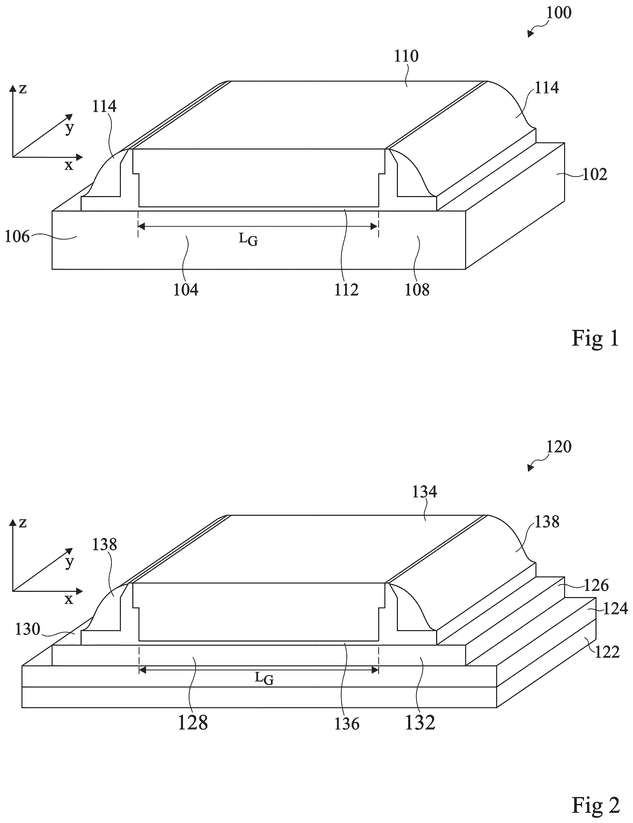

La figure 1 représente un premier exemple d'un transistor MOSFET 100 caractérisé lors d'un procédé de caractérisation mis en œuvre pour déterminer si un diélectrique de ce transistor 100 a été soumis, lors de la fabrication du transistor 100, à un recuit de nitruration.

Dans ce premier exemple, le transistor 100 est de type N et comprend une architecture de type « bulk ». Le transistor 100 comporte un substrat massif 102, ou substrat « bulk », comprenant par exemple un semi-conducteur tel que du silicium. Dans le substrat 102, un canal 104 est formé entre une région de source 106 et une région de drain 108, à proximité d'une surface supérieure du substrat 102. Le canal 104 est contrôlé de manière électrostatique par une grille conductrice 110 comprenant, dans cet exemple, du silicium polycristallin, ou polysilicium. Un diélectrique de grille 112, ou oxyde de grille, est interposé entre le canal 104 et la grille 110. Selon un exemple de réalisation, le diélectrique de grille 112 comporte du SiO₂, et une épaisseur (dimension parallèle à l'axe Z visible sur la figure 1) égale 5,6 nm, ou plus généralement comprise entre 5,2 nm et 6 nm. Le transistor 100 comporte en outre des espaceurs de grille 114 comprenant au moins un matériau diélectrique, disposés sur le substrat 102 et entre lesquels la grille 110 est disposée.

L'architecture bulk de ce transistor 100 est simple, peu coûteuse et bien maîtrisée. Toutefois, elle présente certaines limitations en termes de performance, à très petites échelles, notamment des courants de fuite importants et des effets de canal court.

La figure 2 représente un deuxième exemple de transistor MOSFET 120 caractérisé lors d'un procédé de caractérisation mis en œuvre pour déterminer si un diélectrique de grille de ce transistor 120 a été soumis, lors de la fabrication du transistor 120, à un recuit de nitruration.

Dans ce deuxième exemple, le transistor 120 est de type N et comprend une architecture de type « FD-SOI » (« Fully-Depleted Silicon-On-Insulator » en anglais, ou silicium sur isolant totalement déserté). Le transistor 120 est réalisé à partir d'un substrat FD-SOI comprenant une couche support 122 comprenant par exemple un semi-conducteur tel que du silicium et formant un plan de masse (« ground plane » en anglais) du transistor 120, une couche diélectrique enterrée 124, ou BOX (« Buried Oxide » en anglais) comprenant par exemple du SiO₂, et une couche superficielle 126 comprenant un semi-conducteur, par exemple du silicium. La couche superficielle 126 est structurée, ou gravée, de manière à former, dans la couche superficielle 126, un canal 128 disposé entre une région de source 130 et une région de drain 132. Par exemple, l'épaisseur (dimension parallèle à l'axe Z visible sur la figure 2) de la couche diélectrique enterrée 124 est égale à 25 nm et celle de la couche superficielle 126 est égale à 24 nm.

Comme pour le transistor 100, le canal 128 du transistor 120 est contrôlé de manière électrostatique par une grille conductrice 134 comprenant, dans cet exemple, du silicium polycristallin et une épaisseur (dimension parallèle à l'axe Z visible sur la figure 2) par exemple égale à 40 nm. Un diélectrique de grille 136 est interposé entre le canal 128 et la grille 134. Selon un exemple de réalisation, le diélectrique de grille 136 comporte du SiO₂, et une épaisseur égale 5,2 nm ou plus généralement comprise entre 4,8 nm et 5,6 nm. Le transistor 120 comporte en outre des espaceurs de grille 138 comprenant au moins un matériau diélectrique, disposés sur la couche superficielle 126 et entre lesquels la grille 134 est disposée.

Une telle architecture FD-SOI de ce transistor 120 a pour effet d'éliminer les interactions entre la région active (c'est-à-dire le canal 128, la région de source 130 et la région de drain 132) et la couche support 122. Elle permet d'obtenir un excellent contrôle du canal et une faible consommation énergétique, avec l'avantage d'ajuster dynamiquement le seuil de conduction du transistor via un potentiel électrique appliqué sur le plan de masse formé par la couche support 122.

Un recuit de nitruration, ou recuit nitruré, peut être mis en œuvre lors de la réalisation de MOSFETs à base de silicium, tels que ceux décrits ci-dessus en lien avec les figures 1 et 2, pour améliorer leurs performances et leur fiabilité électrique.

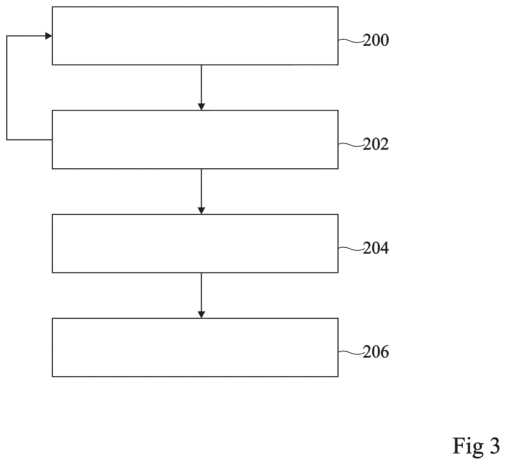

Un exemple de procédé de caractérisation d'un transistor MOSFET, permettant de déterminer si ce transistor a subi un recuit de nitruration lors de sa réalisation, est décrit ci-dessous en lien avec la figure 3. Ce procédé est par exemple mis en œuvre sur l'un des transistors 100 ou 120 précédemment décrits.

Au cours d'une première étape 200, plusieurs applications d'une tension de contrainte V_{GStress} non nulle sur la grille du transistor, déclenchant un piégeage de charges électriques issues du canal du transistor dans le diélectrique de grille du transistor, sont mises en œuvre, et plusieurs déterminations d'une valeur d'un première caractéristique électrique du transistor sont réalisées, chacune mise en œuvre entre deux applications successives de la tension de contrainte V_{GStress} sur la grille du transistor.

La mise en œuvre de la première étape 200 correspond à plusieurs applications de la tension de contrainte non nulle V_{GStress}, pendant une durée totale t_{Stress}, sur la grille du transistor. Cette première étape 200 permet d'introduire une instabilité électrique qui se traduit par un décalage de la tension de seuil V_{TH} du transistor, l'importance de ce décalage dépendant notamment de la valeur de la tension de contrainte V_{GStress} appliquée sur la grille du transistor, de la durée t_{Stress} et de la température T à laquelle est soumise le transistor pendant cette première étape 200.

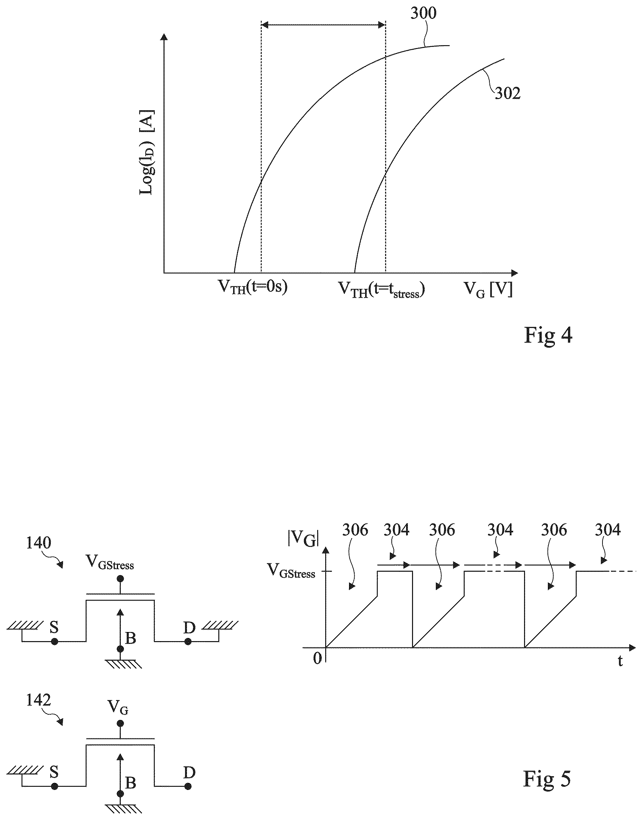

A titre d'illustration, la courbe 300 de la figure 4 représente la caractéristique I_{D}(V_{G}) d'un transistor MOSFET, avec I_{D} correspondant au courant de drain du transistor et V_{G} la tension appliquée sur la grille du transistor, avant la mise en œuvre de la première étape 200, et la courbe 302 représente la caractéristique I_{D}(V_{G}) du transistor après une mise en œuvre de la première étape 200. Ces courbes montrent qu'un décalage de la caractéristique I_{D}(V_{G}) du transistor est obtenu à l'issue de la première étape 200. Ce décalage de la caractéristique I_{D}(V_{G}) se traduit par un décalage de tension de seuil V_{TH} du transistor, et est lié à un piégeage de charges provenant du canal de conduction du transistor vers des pièges se trouvant au moins dans le diélectrique de grille du transistor, et éventuellement à l'interface entre le diélectrique de grille et la grille. Selon les conditions de mise en œuvre de la première étape 200, ce piégeage de charges peut être réversible, c'est-à-dire que les charges initialement piégées peuvent retourner dans le canal du transistor en appliquant une tension de grille de plus petite valeur que la tension de contrainte V_{GStress}, appelée tension de récupération V_{GRecovery}, si les charges ont été piégées dans le diélectrique de grille

Dans l'exemple décrit, la valeur de la tension de contrainte V_{GStress} est comprise entre deux et trois fois la valeur de la tension de grille V_{G} appliquée lors d'un fonctionnement classique du transistor, par exemple en commutation. Par exemple, la valeur de la tension de contrainte V_{GStress} est comprise entre 3,75 V et 6 V. En outre, la valeur de la tension de contrainte V_{GStress} est ici telle qu'un champ électrique E appliqué sur le diélectrique de grille du transistor soit supérieur à 9 MV/cm, avec : $E = {V}_{GStress} / {T}_{OX} ,$ avec T_{OX} correspondant à l'épaisseur du diélectrique de grille du transistor.

Dans l'exemple décrit, la tension de contrainte V_{GStress} est une tension de valeur continue. En variante, la tension de contrainte V_{GStress} pourrait correspondre à une tension en créneaux.

Comme indiqué précédemment, la première étape 200 est mise en œuvre en soumettant le transistor à une température T, celle-ci pouvant être comprise entre 25°C et 200°C. Selon un exemple de réalisation, la température T est égale à 125°C.

En outre, la durée totale t_{Stress} des applications de la tension de contrainte V_{GStress} sur la grille du transistor est par exemple supérieure 1 seconde, et par exemple égale à 10³ secondes. Plus généralement, la durée t_{Stress} est choisie ici comme étant comprise entre 100 secondes et 10⁵ secondes.

Dans l'exemple de réalisation décrit, au cours de la première étape 200, plusieurs déterminations d'une première caractéristique électrique de conduction du transistor sont également réalisées, chacune mise en œuvre entre deux applications successives de la tension de contrainte V_{GStress} sur la grille du transistor. Dans l'exemple décrit, la première caractéristique électrique de conduction du transistor correspond à la tension de seuil V_{TH} du transistor, et les valeurs de la tension de seuil V_{TH} sont chacune déterminées, lors de ces phases de détermination de la valeur de V_{TH}, à partir de mesures du courant de drain I_{D} en fonction de la valeur de la tension de grille V_{G}. En variante, la première caractéristique électrique de conduction du transistor peut correspondre à la valeur I_{DSAT} du courant de drain lorsque le transistor fonctionne en régime saturé, ou à la valeur I_{DLIN} du courant de drain lorsque le transistor fonctionne en régime linéaire. D'autres caractéristiques électriques de conduction du transistor peuvent être déterminées lors de cette première étape 200.

La figure 5 représente un exemple de la tension V_{G} appliquée sur la grille du transistor pendant cette première étape 200. Cette première étape 200 comporte des phases de mise en contrainte du transistor pendant lesquelles la valeur de la tension V_{G} est égale à V_{GStress} (appliquée sous la forme d'une tension continue dans cet exemple). Sur la figure 5, ces phases de mise en contrainte du transistor sont désignées par la référence 304. La durée de chacune de ces phases de mise en contrainte du transistor peut être très variable, dans la mesure où le nombre de caractéristiques I_{D}(V_{G}) est compté par décade de temps. Par exemple, dans la décade 1.10⁻⁶ s à 1.10⁻⁵ s, les phases de mise en contrainte peuvent avoir chacune une durée de l'ordre de quelques microsecondes, tandis que dans la décade 1.10⁴ s à 1.10⁵ s, les phases de mise en contrainte peuvent durer plusieurs dizaines de milliers de secondes. Ainsi, la durée de chacune de ces phases de mise en contrainte du transistor est par exemple comprise entre 1.10⁻⁶ seconde et 1.10⁵ seconde. La référence 142 désigne, sur la figure 5, la configuration du transistor lors de ces phases de mise en contrainte, dans laquelle un potentiel électrique de référence (la masse dans cet exemple) est appliqué sur la source et le drain du transistor, et la tension de contrainte V_{GStress} est appliquée sur la grille du transistor. En outre, dans cet exemple, le potentiel électrique de référence est également appliqué sur le plan de masse du transistor pendant les phases de mise en contrainte du transistor.

La première étape 200 comporte également des phases de mesure, alternées avec les phases de mise en contrainte du transistor, pendant lesquelles la valeur de la tension V_{G} croît graduellement de la valeur nulle jusqu'à la tension d'opération du transistor. Dans l'exemple décrit, chacune de ces phases de mesure est mise en œuvre pendant une durée inférieure à 10 µs, et par exemple comprise entre 1 µs et 1 seconde. Sur l'exemple de la figure 5, la tension V_{G} croît, pendant chacune des phases de mesure, graduellement en formant un signal en escalier. La référence 306 désigne, sur la figure 5, ces phases de mesure. La référence 142 désigne, sur la figure 5, la configuration du transistor lors de ces phases de mesure, dans laquelle un potentiel électrique de référence est appliqué sur la source du transistor, et un circuit de lecture du courant de drain du transistor (non représenté sur la figure 5) est couplé au drain du transistor. En outre, dans cet exemple, le potentiel électrique de référence est également appliqué sur le plan de masse du transistor pendant les phases de mesure.

Le passage d'une phase de mesure à une phase de mise en contrainte du transistor est réalisé en appliquant la valeur de la tension de contrainte V_{GStress} sur la grille du transistor et en appliquant le potentiel électrique de référence sur le drain du transistor. Le passage d'une phase de mise en contrainte du transistor à une phase de mesure est réalisé en appliquant une tension nulle sur la grille du transistor et en découplant le potentiel électrique de référence du drain du transistor afin de pouvoir coupler le circuit de lecture de courant au drain du transistor.

Au cours d'une deuxième étape 202 mise en œuvre après la première étape 200, plusieurs applications d'une tension de récupération, ou de relaxation, V_{GRecovery} sur la grille du transistor, déclenchant une libération des charges électriques piégées dans le diélectrique de grille lors de la première étape 200 vers le canal, sont mises en œuvre, et plusieurs déterminations d'une valeur de la première caractéristique électrique de conduction du transistor sont réalisées, chacune mise en œuvre entre deux applications successives de la tension de récupération V_{GRecovery} sur la grille du transistor. La mise en œuvre de la deuxième étape 202 correspond à plusieurs applications de la tension de récupération V_{GRecovery} pendant une durée totale appelée t_{Recovery}, sur la grille du transistor. Cette deuxième étape 202 permet de réaliser une récupération, c'est-à-dire ici une libération des charges précédemment piégées lors de la première étape 200, ces charges retournant dans le canal.

Dans l'exemple décrit, la valeur de la tension de récupération V_{GRecovery} est nulle. Toutefois, il est possible que la valeur de la tension de récupération V_{GRecovery} soit non nulle et inférieure à V_{GStress}.

La deuxième étape 202 est mise en œuvre en soumettant le transistor à une température par exemple similaire à celle à laquelle est soumis le transistor lors de la première étape 200.

En outre, dans l'exemple décrit, la durée totale t_{Recovery} des applications de la tension de récupération V_{GRecovery} sur la grille du transistor est supérieure à 1 seconde, et par exemple égale à 10³ secondes. Plus généralement, la durée t_{Recovery} est choisie ici comme étant comprise entre 1.10⁻⁶ s et 1.10⁵ s.

Dans l'exemple de réalisation décrit, au cours de la deuxième étape 202, plusieurs déterminations d'une valeur de la tension de seuil V_{TH} du transistor sont donc réalisées, chacune mise en œuvre entre deux applications successives de la tension de récupération V_{GRecovery} sur la grille du transistor. Dans l'exemple décrit, les valeurs de la tension de seuil V_{TH} sont chacune déterminées, lors de ces phases de détermination de la valeur de V_{TH}, à partir de mesures du courant de drain I_{D} en fonction de la valeur de la tension de grille V_{G}.

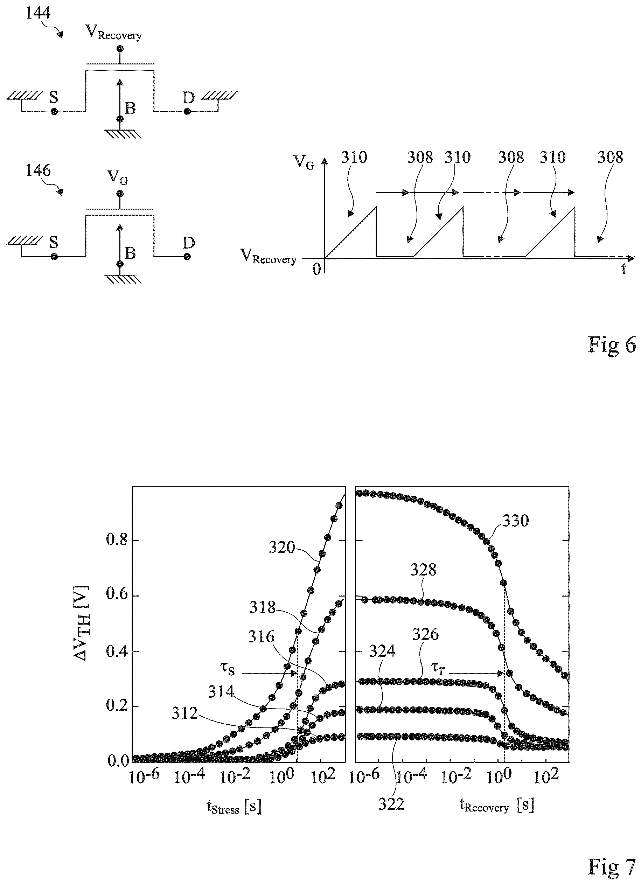

La figure 6 représente un exemple de la tension V_{G} appliquée sur la grille du transistor pendant cette deuxième étape 202. Cette deuxième étape 202 comporte des phases de récupération du transistor pendant lesquelles la valeur de la tension V_{G} est égale à V_{GRecovery} (correspondant à une tension nulle dans cet exemple). Sur la figure 6, ces phases de récupération sont désignées par la référence 308. La durée de chacune de ces phases de récupération du transistor est par exemple comprise entre 1.10⁻⁶ s et 1.10⁵ s. La référence 144 désigne, sur la figure 6, la configuration du transistor lors de ces phases de récupération, dans laquelle un potentiel électrique de référence (la masse dans cet exemple) est appliqué sur la source et le drain du transistor, et la tension de récupération V_{GRecovery} est appliquée sur la grille du transistor. En outre, dans cet exemple, le potentiel électrique de référence est également appliqué sur le plan de masse du transistor pendant les phases de récupération du transistor.

La deuxième étape 202 comporte également des phases de mesure, alternées avec les phases de récupération du transistor, pendant lesquelles la valeur de la tension V_{G} croît graduellement de la valeur nulle jusqu'à environ la tension d'opération du transistor. Dans l'exemple décrit, chacune de ces phases de mesure est mise en œuvre pendant une durée inférieure à 10 µs, et par exemple comprise entre 1 µs et 1 s. Sur l'exemple de la figure 6, la tension V_{G} croît, pendant chacune des phases de mesure, graduellement en formant un signal en escalier. La référence 310 désigne, sur la figure 6, ces phases de mesure. La référence 146 désigne, sur la figure 6, la configuration du transistor lors de ces phases de mesure, dans laquelle un potentiel électrique de référence est appliqué sur la source du transistor, et un circuit de lecture du courant de drain du transistor (non représenté sur la figure 6) est couplé au drain du transistor. En outre, dans cet exemple, le potentiel électrique de référence est également appliqué sur le plan de masse du transistor pendant les phases de mesure.

Le passage d'une phase de mesure à une phase de récupération du transistor est réalisé en appliquant la valeur de la tension de récupération V_{GRecovery} sur la grille du transistor et en appliquant le potentiel électrique de référence sur le drain du transistor. Le passage d'une phase de récupération du transistor à une phase de mesure est réalisé en appliquant une tension nulle sur la grille du transistor et en découplant le potentiel électrique de référence du drain du transistor afin de pouvoir couplée le circuit de lecture de courant au drain du transistor.

Ces première et deuxième étapes 200, 202 sont répétées en utilisant au moins deux valeurs différentes de la tension de contrainte V_{GStress}, et par exemple trois valeurs différentes de V_{GStress}.

Ensuite, une troisième étape 204 est mise en œuvre, comprenant un calcul, à partir des valeurs de la tension de seuil V_{TH} précédemment déterminées lors des premières et deuxièmes étapes 200, 202, d'une dérive Δ d'une deuxième caractéristique électrique du transistor telle que :
[Math 2] $Δ = {\left[{Δ}_{SAT}^{- 1}+{Δ}_{0}⋅{V}_{GStress}^{- p}⋅{t}_{Stress}^{- n}⋅exp\left(\frac{{E}_{a}}{{K}_{B} T}\right)\right]}^{- 1}$ avec Δ0 correspondant à une valeur constante, Δ_{SAT} correspondant à une valeur vers laquelle la dérive Δ sature, ou tend, p correspondant à un facteur d'accélération en tension, n correspondant à un facteur d'accélération temporelle, Ea correspondant à une énergie d'activation, K_{B} la constante de Boltzmann.

Les mesures de la première caractéristique électrique de conduction réalisées lors des premières et deuxièmes étapes 200, 202 sont donc utilisées pour déterminer des transitoires, c'est-à-dire la dérive Δ, d'une deuxième caractéristique électrique de conduction du transistor. Par exemple, la dérive Δ peut correspondre à une dérive ΔV_{TH} de la tension de seuil V_{TH}, ou à une dérive ΔI_{DSAT} du courant de drain lorsque le transistor est en régime saturé (c'est-à-dire lorsque V_{DS} > V_{GS} - V_{TH}), ou à une dérive ΔI_{DLIN} du courant de drain lorsque le transistor est en régime linéaire (c'est-à-dire lorsque V_{DS} < V_{GS} - V_{TH}). D'autres caractéristiques électriques de conduction du transistor sont envisageables. En outre, la première caractéristique électrique de conduction du transistor peut être similaire ou non à la deuxième caractéristique électrique de conduction du transistor.

La figure 7 montre des courbes de la dérive ΔV_{TH}, en volts, obtenues à partir des mesures réalisées lors des première et deuxième étapes 200, 202 du procédé de caractérisation précédemment décrit, pour différentes valeurs de la tension de contrainte V_{GStress}, en fonction des durées t_{Stress} et t_{Recovery}. Plus particulièrement, la courbe 312 désigne la dérive ΔV_{TH} déterminée à partir des mesures réalisées lors de la première étape 200 lorsque V_{GStress} = 0,25 V, la courbe 314 désigne la dérive ΔV_{TH} déterminée à partir des mesures réalisées lors de la première étape 200 lorsque V_{GStress} = 0,75 V, la courbe 316 désigne la dérive ΔV_{TH} déterminée à partir des mesures réalisées lors de la première étape 200 lorsque V_{GStress} = 1,5 V, la courbe 318 désigne la dérive ΔV_{TH} déterminée à partir des mesures réalisées lors de la première étape 200 lorsque V_{GStress} = 3 V, et la courbe 320 désigne la dérive ΔV_{TH} déterminée à partir des mesures réalisées lors de la première étape 200 lorsque V_{GStress} = 5 V. En outre, la courbe 322 désigne la dérive ΔV_{TH} déterminée à partir des mesures réalisées lors de la deuxième étape 202 lorsque V_{GStress} = 0,25 V, la courbe 324 désigne la dérive ΔV_{TH} déterminée à partir des mesures réalisées lors de la deuxième étape 202 lorsque V_{GStress} = 0,75 V, la courbe 326 désigne la dérive ΔV_{TH} déterminée à partir des mesures réalisées lors de la deuxième étape 202 lorsque V_{GStress} = 1,5 V, la courbe 328 désigne la dérive ΔV_{TH} déterminée à partir des mesures réalisées lors de la deuxième étape 202 lorsque V_{GStress} = 3 V, et la courbe 330 désigne la dérive ΔV_{TH} déterminée à partir des mesures réalisées lors de la deuxième étape 202 lorsque V_{GStress} = 5 V. Ces différentes courbes sont obtenues pour un transistor MOSFET ayant une longueur de grille égale à 1 µm, une largeur de grille égale à 8 mm et à une température de fonctionnement du transistor égale à 25°C.

Au cours d'une quatrième étape 206, à partir de l'équation (1) ci-dessus, il est possible de calculer la valeur du facteur d'accélération en tension p, et de déterminer que le diélectrique de grille du transistor a été soumis à un recuit de nitruration si la valeur du facteur d'accélération en tension p vérifie la relation :
[Math 3] $p = a \times {T}_{OX} + b$ avec « a » une constante comprise entre 2 et 7 et « b » une constante comprise entre -3 et 7, et Tₒₓ en nm. Dans l'exemple de réalisation décrit, la constante « a » est égale à 4,71, et la constante « b » est égale à -1,83.

Ainsi, si la valeur de p déterminée vérifie l'équation (2) ci-dessus, cela signifie que le diélectrique de grille du transistor a bien subi, lors du procédé de réalisation du transistor, une étape de recuit de nitruration. Au contraire, si la valeur de p déterminée ne vérifie pas l'équation (2) ci-dessus, cela signifie que le diélectrique de grille du transistor n'a pas subi, lors du procédé de réalisation du transistor, une étape de recuit de nitruration.

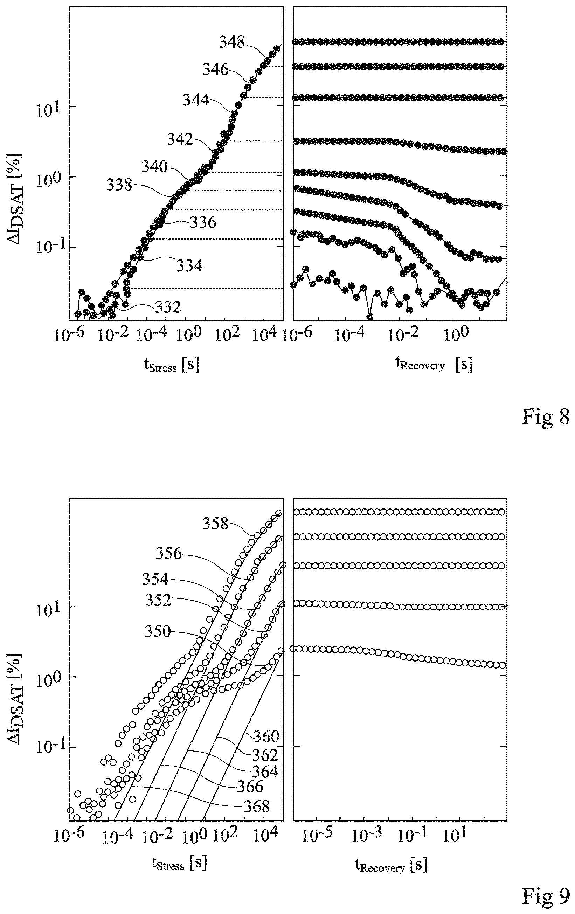

La figure 8 représente des exemples de mesures de dérives ΔI_{DSAT}, exprimées en %, du courant de drain I_{D} obtenu dans un transistor MOSFET de type FD-SOI, fonctionnant en régime de saturation. Ces dérives sont obtenues à partir des mesures réalisées lors des première et deuxième étapes 200, 202 d'un procédé de caractérisation, pour différentes valeurs des durées t_{Stress} et t_{Recovery}. Ces courbes sont obtenues en appliquant une tension de contrainte V_{GStress} = 5 V, à une température T égale à 125°C, et avec un diélectrique de grille comprenant du SiO₂ d'épaisseur égale à 5,25 nm et soumis à un recuit de nitruration lors de sa réalisation.

Plus particulièrement, la courbe 332 représente la dérive ΔI_{DSAT} obtenue pour une durée t_{Stress} égale à 10⁻³ s, la courbe 334 représente la dérive ΔI_{DSAT} obtenue pour une durée t_{Stress} égale à 10⁻² s, la courbe 336 représente la dérive ΔI_{DSAT} obtenue pour une durée t_{Stress} égale à 10⁻¹ s, la courbe 338 représente la dérive ΔI_{DSAT} obtenue pour une durée t_{Stress} égale à 1 s, la courbe 340 représente la dérive ΔI_{DSAT} obtenue pour une durée t_{Stress} égale à 10 s, la courbe 342 représente la dérive ΔI_{DSAT} obtenue pour une durée t_{Stress} égale à 10² s, la courbe 344 représente la dérive ΔI_{DSAT} obtenue pour une durée t_{Stress} égale à 10³ s, la courbe 346 représente la dérive ΔI_{DSAT} obtenue pour une durée t_{Stress} égale à 10⁴ s, et la courbe 348 représente la dérive ΔI_{DSAT} obtenue pour une durée t_{Stress} égale à 10⁵ s.

Pendant la phase de mise sous contrainte du transistor, ces courbes montrent qu'une dérive significative du courant de drain est obtenue pour une durée t_{Stress} supérieure à 10⁻³ s, ce qui correspond à la présence d'une première population de pièges dans le diélectrique de grille. Une légère saturation est observée lorsque la durée t_{Stress} est égale à environ 10 s, suivie d'une deuxième augmentation importante de la dérive ΔI_{DSAT} pour une durée t_{Stress} supérieure à 10 s, ce qui indique la présence d'une deuxième population de pièges pour de telles durées, cette deuxième population de pièges étant présente à l'interface entre le diélectrique de grille et la grille. Cette observation se confirme avec les variations de la dérive observées lors de la phase de récupération. En effet, lorsque t_{Stress} < 10² s, la relaxation de la dérive se produit lorsque la valeur de t_{Recovery} se situe autour de 10⁻¹ s à 1 s, avec une relaxation complète de la première population de pièges, qui est donc récupérable. Lorsque t_{Stress} > 10² s, il n'y a plus de relaxation de la dérive. La deuxième population de pièges est donc, quant à elle, quasi-permanente, ce qui se traduit par une absence de baisse de la dérive ΔI_{DSAT} même après une durée t_{Recovery} importante, par exemple supérieure à 1 s. La durée t_{Stress} pendant laquelle la première étape est mise en œuvre a donc une influence sur le type de pièges dans lesquels les charges sont piégées.

La figure 9 représente des exemples de dérives ΔI_{DSAT}, exprimées en %, du courant de drain obtenu dans le même transistor que celui à partir duquel les courbes de figure 8 ont été obtenues. Plus particulièrement, la courbe 350 représente les mesures obtenues pour une tension de contrainte V_{GStress} égale à 4,25 V, la courbe 352 représente les mesures obtenues pour une tension de contrainte V_{Gstress} égale à 4,5 V, la courbe 354 représente les mesures obtenues pour une tension de contrainte V_{GStress} égale à 4,75 V, la courbe 356 représente les mesures obtenues pour une tension de contrainte V_{GStress} égale à 5 V, et la courbe 358 représente les mesures obtenues pour une tension de contrainte V_{GStress} égale à 5,25 V. En outre, les références 360, 362, 364, 366 et 368 désignent les dérives ΔI_{DSAT} calculées selon l'équation (1) précédente, à partir des mesures 350, 352, 354, 356 et 358 respectivement.

Les courbes de la figure 9 mettent également en évidence l'existence de deux populations différentes de pièges des charges provenant du canal. Lors de la phase de contrainte, les deux populations de pièges sont observées. Par rapport à la population de pièges récupérable, la population de pièges quasi-permanents implique des dérives fortement influencées par la tension, avec un facteur d'accélération en tension p égal à 22,8. La dépendance temporelle, est, quant à elle, caractérisée par une accélération temporelle n égale à 0,47. Pendant la phase de récupération, aucune réversibilité significative des dérives n'est ici observée pour les différentes valeurs de V_{GStress}. Ces courbes montrent que la population de pièges permanents prédomine, ce qui rend les dérives ΔI_{DSAT} quasi-permanentes, avec une réversibilité négligeable ou inexistante. Dans cet exemple, la valeur de Δ_{SAT} est égale à 95,4 %.

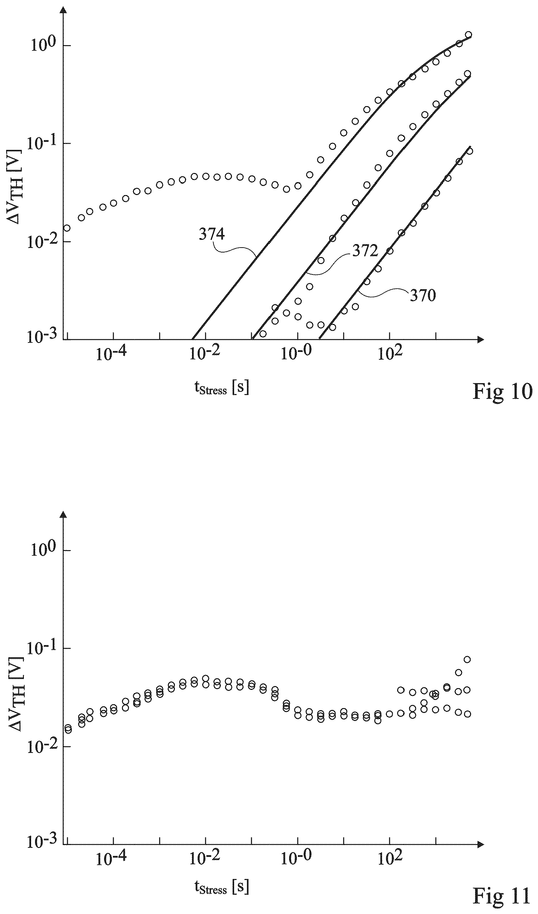

La figure 10 montre des exemples de la dérive ΔV_{TH}, en volt, obtenues à partir des mesures réalisées lors de la première étape du procédé de caractérisation, précédemment décrit, pour différentes valeurs de la tension de contrainte V_{GStress}. Plus particulièrement, la courbe 370 désigne la dérive ΔV_{TH} déterminée à partir des mesures réalisées lors de la première étape 200 lorsque V_{GStress} = 4,8 V, la courbe 372 désigne la dérive ΔV_{TH} déterminée à partir des mesures réalisées lors de la première étape 200 lorsque V_{GStress} = 5,2 V, la courbe 374 désigne la dérive ΔV_{TH} déterminée à partir des mesures réalisées lors de la première étape 200 lorsque V_{GStress} = 5,6 V. Ces différentes courbes sont obtenues pour un transistor MOSFET réalisé sur un substrat bulk, à un température T égale à 125°C et dont le diélectrique de grille à base de SiO₂ et d'épaisseur égale à 5,6 nm a subi un recuit de nitruration. En modélisant les dérives ΔV_{TH} obtenues pour une durée t_{Stress} supérieure à 1 seconde par la loi en puissance définie selon l'équation (1), il est possible de déterminer un facteur d'accélération p égal à 24,6, et un paramètre de dépendance temporelle n égal à 0,61. Dans cet exemple, la valeur de Δ_{SAT} est égale à 1,64 V. Ces valeurs sont relativement proches de celles obtenues dans les exemples précédents faisant appel à un transistor FD-SOI.

La figure 11 montre des mesures de la dérive ΔV_{TH}, en volt, obtenues à partir des mesures réalisées lors de la première étape 200 du procédé de caractérisation, pour différentes valeurs de la tension de contrainte V_{GStress}, allant de 4,8 V à 5,6 V. Ces mesures sont obtenues pour un transistor MOSFET réalisé sur un substrat bulk, à un température T égale à 125°C et dont le diélectrique de grille à base de SiO₂ et d'épaisseur égale à 5,6 nm n'a pas subi un recuit de nitruration. Ces mesures montrent que l'absence de recuit nitruré dans le processus de fabrication du transistor induit une absence de dérive de la tension de seuil.

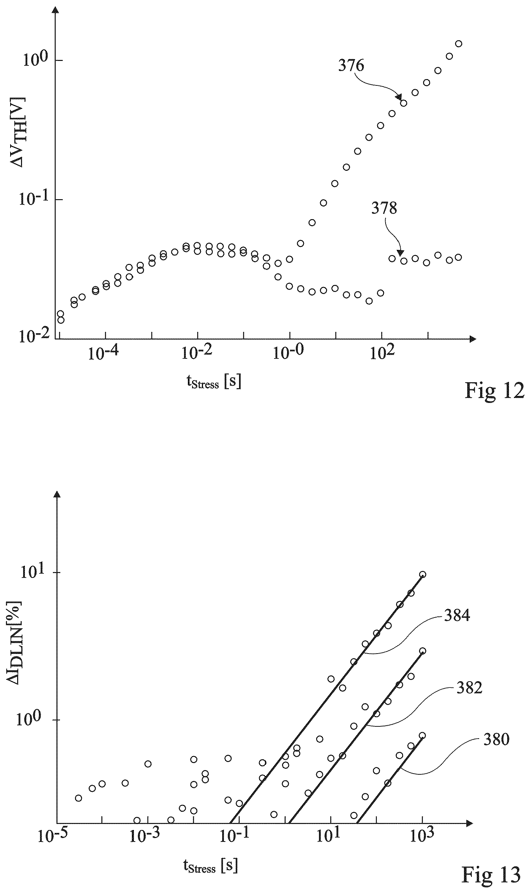

La figure 12 représente des exemples de mesure de la dérive ΔV_{TH}, en volt, de la tension de seuil V_{TH} obtenues à partir de mesures de la tension de seuil V_{TH} lors d'une première étape 200 du procédé de caractérisation précédemment décrit. Plus particulièrement, les mesures 376 correspondent à la dérive ΔV_{TH} déterminée lors de la première étape 200 appliquée au même transistor que celui utilisé pour l'obtention des courbes représentées sur la figure 10, c'est-à-dire dont le diélectrique de grille a subi un recuit de nitruration, et les mesures 378 correspondent à la dérive ΔV_{TH} déterminée lors de la première étape 200 appliquée au même transistor que celui utilisé pour l'obtention des courbes représentées sur la figure 11, c'est-à-dire dont le diélectrique de grille n'a pas subi de recuit de nitruration. Les courbes 376 et 378 sont obtenues lorsque V_{GStress} = 5,6 V, à une température T égale à 125°C. Ces courbes illustrent le fait qu'avec une durée t_{Stress} supérieure à environ 1 s, l'apparition d'une dérive ΔV_{TH} de la tension de seuil V_{TH} est liée à la soumission du diélectrique de grille à un recuit de nitruration lors de la réalisation du transistor.

La figure 13 représente des exemples de dérives ΔI_{DLIN} du courant de drain I_{D} d'un transistor fonctionnant en régime linéaire, obtenues à partir des mesures réalisées lors d'une première étape 200 d'un procédé de caractérisation tel que décrit précédemment, pour différentes valeurs de la tension de contrainte V_{GStress}. Plus particulièrement, la courbe 380 désigne la dérive ΔI_{DLIN} déterminée lors de la première étape 200 lorsque V_{GStress} = 2,6 V, la courbe 382 désigne la dérive ΔI_{DLIN} déterminée lors de la première étape 200 lorsque V_{GStress} = 2,9 V, et la courbe 384 désigne la dérive ΔI_{DLIN} déterminée lors de la première étape 200 lorsque V_{GStress} = 3,2 V. Ces différentes courbes sont obtenues pour un transistor MOSFET réalisé sur un substrat bulk, à un température T égale à 125°C et dont le diélectrique de grille à base de SiO₂ et d'épaisseur égale à 2,7 nm a subi un recuit de nitruration. En modélisant les dérives ΔI_{DLIN} obtenues pour une durée t_{Stress} supérieure à 1 seconde par la loi en puissance définie selon l'équation (1), il est possible de déterminer un facteur d'accélération p égal à 10,89, et un paramètre de dépendance temporelle n égal à 0,61. Dans cet exemple, la valeur de Δ_{SAT} tend vers l'infini.

Les courbes des figures 9 à 12 montrent également qu'avec un diélectrique de plus faible épaisseur, la valeur du facteur d'accélération p est relativement faible par rapport à celle obtenue avec un diélectrique d'épaisseur plus importante.

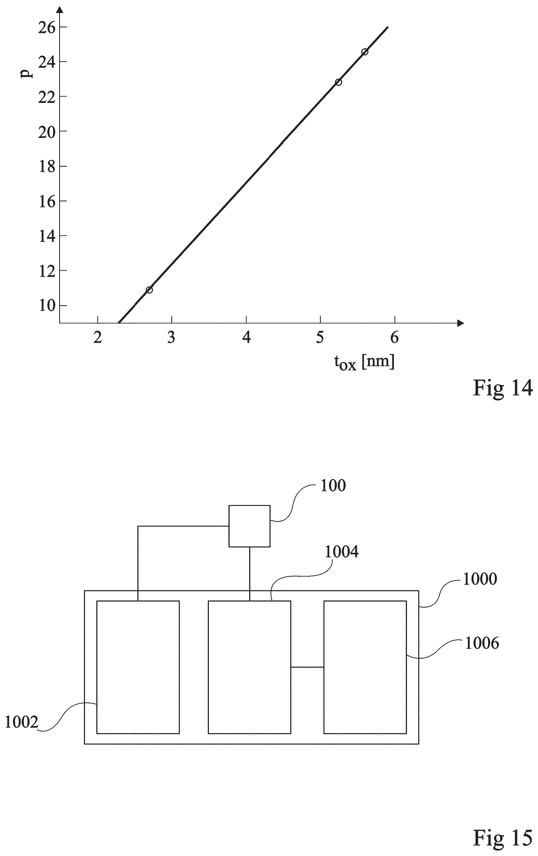

La figure 14 représente un exemple de relation reliant la valeur du facteur d'accélération p à celle de l'épaisseur T_{OX} du diélectrique de grille du transistor auquel le procédé de caractérisation est appliqué. Cette relation correspond ici à l'équation p = 4,71.T_{OX} - 1,83.

Le procédé décrit précédemment est par exemple mis en œuvre pour remonter plus précisément au process ayant permis la fabrication d'un transistor MOSFET. Ce procédé peut venir compléter d'autres techniques d'analyses spectroscopique, microscopique et physico-chimique servant à déterminer les propriétés d'un transistor.

Le procédé décrit précédemment peut également être utilisé dans le cadre du contrôle de qualité industriel pour vérifier si un recuit nitruré a été mis en œuvre sur une plaquette, ou wafer, de semi-conducteur servant à la réalisation de transistors MOSFET.

Le procédé décrit précédemment peut être mis en œuvre par un dispositif 1000 comprenant par exemple un ou plusieurs circuits 1002 d'application de potentiels électriques sur les électrodes du ou des transistors à caractériser (transistor 100 sur l'exemple de la figure 15), ainsi qu'un ou plusieurs circuits 1004 de mesure, par exemple de courant de drain, ainsi qu'un ou plusieurs circuits 1006 de calcul permettant de calculer le facteur d'accélération p et d'en déduire si le ou les transistors caractérisés ont subis, lors de leur réalisation, un recuit de nitruration. Un exemple schématique d'un tel dispositif 1000 est représenté sur la figure 15

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de caractérisation d'un transistor (100, 120) de type MOSFET, comprenant au moins :
a) plusieurs applications (200) d'une tension de contrainte V_{GStress} non nulle sur une grille (110, 134) du transistor (100, 120), déclenchant un piégeage de charges électriques issues d'un canal (104, 128) du transistor (100, 120) au moins dans un diélectrique de grille (112, 136) du transistor (100, 120), et plusieurs déterminations d'une valeur d'une première caractéristique électrique de conduction du transistor (100, 120) chacune mise en œuvre entre deux applications successives de la tension de contrainte V_{Gstress} sur la grille (112, 136), puis
b) plusieurs applications (202) d'une tension de récupération V_{GRecovery} sur la grille (112, 136), déclenchant une libération de charges électriques piégées, et plusieurs déterminations d'une valeur de la première caractéristique électrique de conduction du transistor (100, 120) chacune mise en œuvre entre deux applications successives de la tension de récupération V_{GRecovery} sur la grille (112, 136), puis
c) calcul (204), à partir des valeurs de la première caractéristique électrique de conduction précédemment déterminées en mettant en œuvre les étapes a) et b) avec au moins deux valeurs différentes de la tension de contrainte V_{GStress}, d'une dérive Δ d'une deuxième caractéristique électrique de conduction du transistor (100, 120) selon : $Δ = {\left[{Δ}_{SAT}^{- 1}+{Δ}_{0}⋅{V}_{GStress}^{- p}⋅{t}_{Stress}^{- n}⋅exp\left(\frac{{E}_{a}}{{K}_{B} T}\right)\right]}^{- 1}$ avec Δ₀ une valeur constante, Δ_{SAT} une valeur vers laquelle sature la dérive Δ, p un facteur d'accélération en tension, t_{Stress} une durée totale des applications de la tension de contrainte V_{GStress}, n une accélération temporelle, Ea une énergie d'activation, K_{B} la constante de Boltzmann, puis
d) détermination que le diélectrique de grille (112, 136) a été soumis ou non à un recuit de nitruration selon que la valeur du facteur d'accélération en tension p vérifie ou non la relation p = a×T_{OX} + b, avec T_{OX} l'épaisseur du diélectrique de grille (112, 136), a une constante comprise entre 2 et 7 et b une constante comprise entre -3 et 7.

2. Procédé selon la revendication 1, dans lequel la constante a est égale à 4,71, et/ou la constante b est égale à -1,83.

3. Procédé selon l'une quelconque des revendications précédentes, dans lequel la première et/ou la deuxième caractéristique électrique de conduction du transistor (100, 120) correspond à la tension de seuil V_{TH} du transistor (100, 120), ou au courant de drain I_{DSAT} du transistor (100, 120) lorsque le transistor (100, 120) est en régime saturé, ou au courant de drain I_{DLIN} du transistor (100, 120) lorsque le transistor (100, 120) est en régime linéaire.

4. Procédé selon l'une quelconque des revendications précédentes, dans lequel les valeurs de la première caractéristique électrique de conduction du transistor (100, 120) sont chacune déterminées, lors de la mise en œuvre d'au moins l'une des étapes a) et b), à partir de mesures du courant de drain I_{D} en fonction de la valeur de la tension de grille V_{G}.

5. Procédé selon la revendication 4, dans lequel chaque mesure du courant de drain I_{D} en fonction de la valeur de la tension de grille V_{G}, entre deux applications de la tension de contrainte V_{Gstress} ou de la tension de récupération V_{GRecovery} sur la grille du transistor, est mise en œuvre pendant une durée inférieure à 10 µs.

6. Procédé selon l'une quelconque des revendications précédentes, dans lequel la valeur de la tension de contrainte V_{GStress} est comprise entre deux et trois fois la valeur de la tension de grille V_{G} destinée à être appliquée lors d'un fonctionnement nominal du transistor (100, 120), et/ou la valeur de la tension de contrainte V_{GStress} est telle qu'un champ électrique E appliqué sur le diélectrique de grille (112, 136) soit supérieur à 9 MV/cm, avec E = V_{GStress}/T_{OX}.

7. Procédé selon l'une quelconque des revendications précédentes, dans lequel la tension de contrainte V_{GStress} est une tension continue ou en créneaux.

8. Procédé selon l'une quelconque des revendications précédentes, dans lequel la valeur de la tension de récupération V_{GRecovery} est nulle.

9. Procédé selon l'une quelconque des revendications précédentes, dans lequel les étapes a) et b) sont mises en œuvre en soumettant le transistor (100, 120) à une température comprise entre 25°C et 200°C.

10. Procédé selon l'une quelconque des revendications précédentes, dans lequel la durée totale des applications de la tension de contrainte V_{GStress} sur la grille (110, 134) et/ou la durée totale des applications de la tension de récupération V_{GRecovery} sur la grille (110, 134) est supérieure à 1 seconde.

11. Procédé selon l'une quelconque des revendications précédentes, dans lequel :
- lors de l'étape a), lorsque la tension de contrainte V_{GStress} est appliquée sur la grille (110, 134), un potentiel électrique de référence est appliqué sur une région de source (106, 130) et une région de drain (108, 132) du transistor (100, 120), et/ou
- lors de l'étape b), lorsque la tension de récupération V_{GRecovery} est appliquée sur la grille (110, 134), un potentiel électrique de référence est appliqué sur la région de source (106, 130) et la région de drain (108, 132).

12. Procédé selon l'une quelconque des revendications précédentes, dans lequel le transistor (100, 120) comporte un substrat de type bulk ou FD-SOI.

13. Procédé selon l'une quelconque des revendications précédentes, dans lequel le transistor (100, 120) est de type N.

14. Procédé selon l'une quelconque des revendications précédentes, dans lequel le diélectrique de grille (112, 136) comporte du SiO₂ et/ou la grille (110, 134) comporte du silicium polycristallin dopé.

15. Dispositif (1000) de mise en œuvre d'un procédé de caractérisation d'un transistor (100, 120) de type MOSFET selon l'une quelconque des revendications précédentes.
